(19) Europäisches Patentamt
European Patent Office
Office européen des brevets

(11) Veröffentlichungsnummer : **0 303 572 B1**

(12) # EUROPÄISCHE PATENTSCHRIFT

(45) Veröffentlichungstag der Patentschrift : **15.04.92 Patentblatt 92/16**

(51) Int. Cl.$^5$ : **G03F 1/00**

(21) Anmeldenummer : **88810534.3**

(22) Anmeldetag : **04.08.88**

(54) **Verwendung eines Thermotransferdruckers zur Herstellung einer Photomaske.**

(30) Priorität : **13.08.87 CH 3125/87**

(43) Veröffentlichungstag der Anmeldung : **15.02.89 Patentblatt 89/07**

(45) Bekanntmachung des Hinweises auf die Patenterteilung : **15.04.92 Patentblatt 92/16**

(84) Benannte Vertragsstaaten : **BE CH DE FR GB IT LI NL SE**

(56) Entgegenhaltungen :
**DE-A- 3 537 829**
**DE-C- 543 537**
**DE-C- 658 771**
**DE-C- 661 827**

(56) Entgegenhaltungen :
**FR-A- 2 495 025**
**US-A- 3 697 677**
**XEROX DISCLOSURE JOURNAL, Band 8, Nr. 2, März/April 1983, Seite 91, Stamford, Connecticut, US; J.R. DEBESIS: "Ink jet generated phototools"**
**PATENT ABSTRACTS OF JAPAN, Band 5, Nr. 36 (P-51)[708], 7. März 1981, Seite 64 P 51; & JP-A-55 157 737 (HAMASAWA KOGYO K.K.) 08-12-1980**

(73) Patentinhaber : **CIBA-GEIGY AG**
**Klybeckstrasse 141**
**CH-4002 Basel (CH)**

(72) Erfinder : **Mizuguchi, Jin, Dr.**
**Rte de Schiffenen 7**
**CH-1700 Fribourg (CH)**

EP 0 303 572 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein Verfahren zur direkten Herstellung einer Photomaske aus elektronisch kodierten Informationsquellen auf einer, ein im Bereich von 350 bis 450 nm lichtempfindliches Photopolymer enthaltenden Metallplatte (pre-sensitized plate; nachfolgend als PS-Platte bezeichnet) mittels eines Thermotransferdruckers und eines Farbbandes, enthaltend ein Pigment oder einen Farbstoff, welche Licht im Bereich von 350 bis 450 nm absorbieren.

In der EP-Anmeldung 0 065 760 wird unter anderem vorgeschlagen, auf eine PS-Platte eine Photomaske nach mechanischem, elektromagnetischem oder thermischem Bildherstellungsverfahren, wie Drucken, magnetisches Toneraufbringen oder thermisch verwendete Laserbelichtung, direkt aufzubringen. Für das Drucken der Photomaske auf der PS-Platte wird Tinte verwendet, und für die Herstellung einer Photomaske auf der PS-Platte auf der Basis von elektronischen Informationen wird die Laserbeschriftung eingesetzt, wobei in diesem Fall die ganze Fläche der PS-Platte mit einer pigmenthaltigen Schicht versehen sein muss.

In der DE-OS 35 37 829 wird ein Verfahren zur Herstellung von Druckvorlagen offenbart, wobei unter anderem das Druckmuster mittels eines Thermodruckers direkt auf die lichtempfindliche Schicht aufgebracht wird, die aber keine Deckschicht aufweist. Zur Verbesserung der Haftfestigkeit des Druckmusters auf der Oberfläche der Trägerschicht wird diese vorzugsweise aufgerauht.

Im Xerox Disclosure Journal, Vol. 8, No. 2 March/April 1983, wird zur Herstellung einer Photomaske kein Thermodrucker, sondern das Tintenspritzverfahren eingesetzt, wobei die Photomaske nicht direkt auf die lichtempfindliche Schicht, sondern auf einen darüber liegenden transparenten Polyesterfilm oder auf Glas aufgetragen wird. Abgesehen davon, dass eine solche Photomaske noch getrocknet werden muss, ergibt sie Abzüge mit keinem hohen Auflösungsvermögen.

Es wurde nun gefunden, dass man bei Verwendung eines Thermotransferdruckers und eines Farbbandes, enthaltend ein Pigment oder einen Farbstoff, welche im Bereich von 350 bis 450 nm Licht absorbieren zur direkten Herstellung einer Photomaske auf einer PS-Platte nach dem Belichten und Entwickeln der belichteten PS-Platte Druckplatten erhält, die zur Herstellung von Abzügen mit hohem Auflösungsvermögen nach dem Bilddruckverfahren geeignet sind.

Thermotransferdrucker sind seit langem bekannt und werden bekanntlich zum Schreiben von Informationen auch aus elektronisch kodierten Quellen eingesetzt, wobei je nach verwendetem Farbband normales glattes Papier oder thermisch empfindliches Druckpapier eingesetzt wird.

Gegenstand der vorliegenden Erfindung ist somit ein Verfahren zur Herstellung einer Photomaske auf einer sich auf einer Metallplatte befindenden Schicht eines lichtempfindlichen, positiv arbeitenden Photopolymer, durch bildweises Aufzeichnen elektronisch kodierter Informationsquellen eines Thermotransferdruckers mittels eines Farbbands, dadurch gekennzeichnet, dass (a) das Photopolymer im Bereich von 350 bis 450 nm lichtempfindlich ist, (b) das Farbband ein Pigment oder einen Farbstoff enthält, welche im Bereich von 350 bis 450 nm Licht absorbieren, (c) auf der Photopolymerschicht eine Deckschicht aus einem in alkalischer Lösung löslichen und im Bereich von 350 bis 450 nm lichtdurchlässigen Polymer aufgebracht ist und die Photomaske direkt auf diese Deckschicht aufgezeichnet wird. Die erfindungsgemäss hergestellte Photomaske wird vorzugsweise für eine Integralbelichtung verwendet.

Die zur Herstellung der Photomaske verwendeten, ein Pigment oder einen Farbstoff enthaltenden Farbbänder sind bekannt. Als Farbbänder, die bei der Herstellung der Photomaske mittels eines Thermotransferdruckers eingesetzt werden können, eignen sich sowohl solche vom Schmelztyp als auch vom Sublimationstyp. Zur Herstellung einer Photomaske mittels eines Thermotransferdruckers werden bevorzugt Farbbänder vom Schmelztyp eingesetzt. Solche Schmelzfarbbänder enthalten beispielsweise etwa 20 Gew.-% eines Pigmentes, etwa 60 bis etwa 80 Gew.-% Wachs und 0 bis etwa 20 Gew.-% übliche Zusätze. Als Wachs können im Farbband beispielsweise Karnaubawachs, Esterwachs oder Paraffinwachs enthalten sein und übliche Zusätze sind beispielsweise Oel, Stabilisatoren oder Antioxidantien.

Farbbänder vom Sublimationstyp enthalten im wesentlichen einen sublimierbaren Farbstoff, der entweder unter Hochvakuum direkt auf ein Kondensationspapier aufgedampft wird oder in Form einer Suspension, beispielsweise in Nitrocellulose, mit einer Spiralwalze auf ein Kondensatorpapier aufgetragen wird.

Falls das Pigment oder der Farbstoff im Bereich von 350 bis 450 nm nicht genügend absorbiert, ist zur Herstellung der Photomaske ein Farbband zu verwenden, das zusätzlich noch etwa 5 Gew.-%, bezogen auf die zuvor angegebene Zusammensetzung der Farbbänder, eines optischen Aufhellers oder UV-Absorbers enthält, welche im Spektralbereich, in dem das Photopolymer lichtempfindlich ist, Licht absorbieren.

Zur Herstellung der Photomasken verwendet man im allgemeinen Farbbänder, die ein gelbes, rotes, grünes oder schwarzes Pigment oder einen gelben, roten, grünen oder schwarzen Farbstoff enthalten, welche im Bereich von 350 bis 450 nm Licht absorbieren. Bei der Herstellung der Photomaske und der Entwicklung der belichteten PS-Platte arbeitet man mit Vorteil in einem UV-freien, gelb beleuchteten Raum. Zur besseren

Erkennbarkeit der im gelben Licht mittels des Thermotransferdruckers aufgetragenen Photomaske empfiehlt es sich daher, dem Farbband ein blaues Pigment oder einen blauen Farbstoff als Komplementärfarbe von gelb zuzugeben. Vorzugsweise enthalten die blauen Farbbänder noch einen optischen Aufheller oder einen UV-Absorber.

Die in den Farbbändern enthaltenen Pigmente, Farbstoffe, optischen Aufheller oder UV-Absorber sind ebenfalls bekannt und zum Teil im Handel erhältlich.

Zur Herstellung der Farbbänder geeignete Pigmente, die Licht im Bereich von 350 bis 450 nm absorbieren, sind beispielsweise Cromophthal Gelb 6G, Irgazin Gelb 2GLT und Irgalith GO, die unter dieser Bezeichnung im Handel von der CIBA-GEIGY AG erhältlich sind.

Als Farbstoffe, die Licht im Bereich von 350 bis 450 nm absorbieren, eignen sich beispielsweise gelbe Pyrazolonfarbstoffe, wie Tartrazin, schwarze Farbstoffe wie die im Handel unter der Bezeichnung "Spezialschwarz 7984" und "Diphenylschwarz GN" erhältlichen schwarzen Farbstoffe, rote Farbstoffe, wie der unter der Bezeichnung "Acid Red 35" von Sumitomo im Handel erhältliche rote Farbstoff oder die Leukofarbstoffe, wie solche der folgenden Formeln

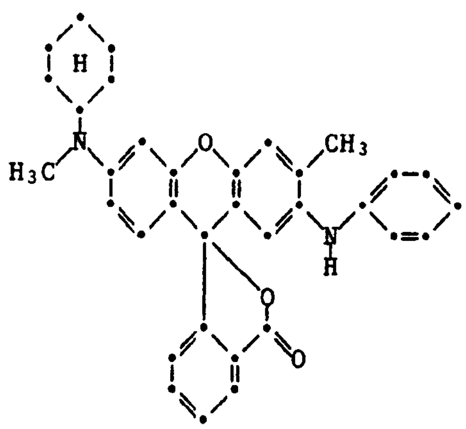

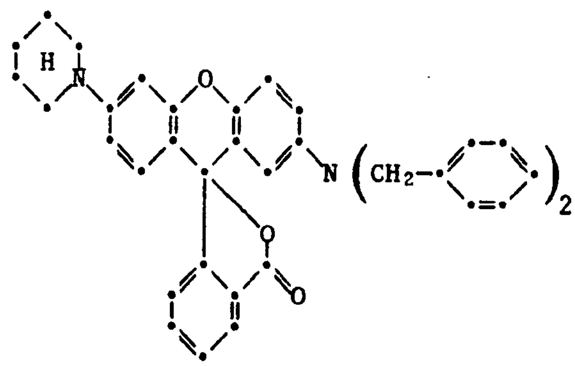

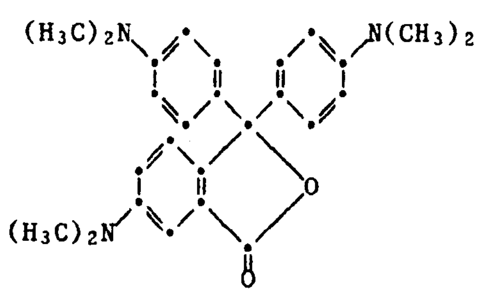

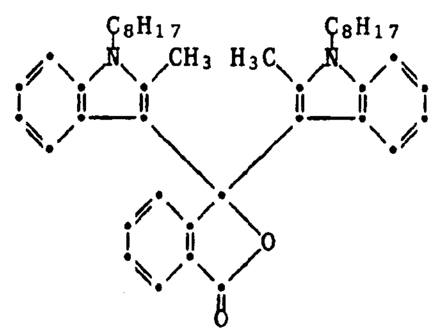

oder

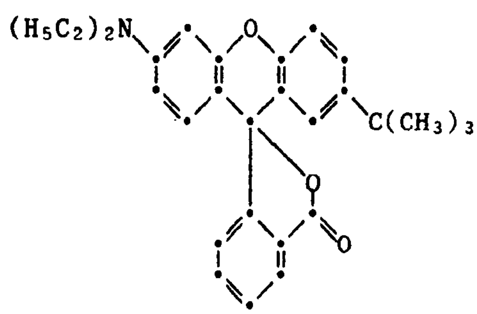

Geeignete optische Aufheller, die gegebenenfalls im Farbband enthalten sind und ebenfalls Licht im Bereich von 350 bis 450 nm absorbieren, sind beispielsweise solche, die den folgenden Formeln entsprechen

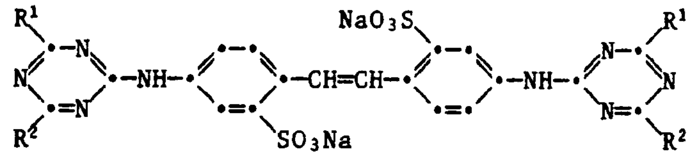

worin $R^1$ je für ein Anilino oder mit $Na_2SO_3$ mono- oder disubstituiertes Anilino und $R^2$ je für Methoxy, Morpholino oder Di-(2-hydroxyethyl)-amino stehen,

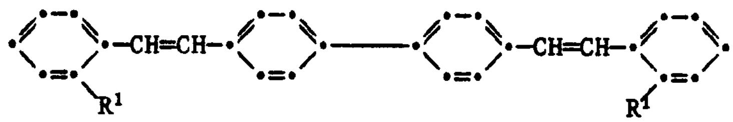

worin $R^1$ je für Methoxy, Cyano oder $Na_2SO_3$ steht,

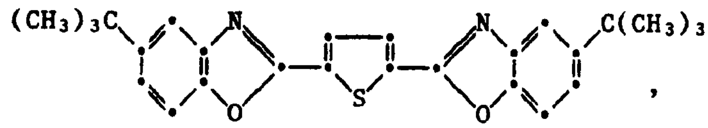

,

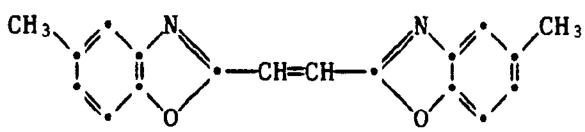

,

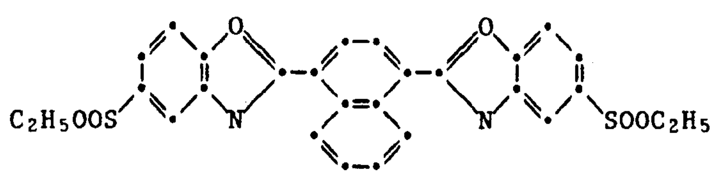

oder

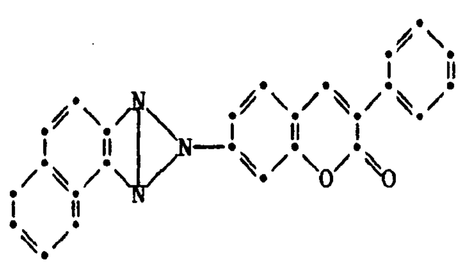

.

Als UV-Absorber, die Licht im Bereich von 350 bis 450 nm absorbieren und gegebenenfalls in den Farbbändern enthalten sind, sind beispielsweise die UV-Absorber vom 2-Hydroxy- oder 2,4-Dihydroxybenzophenon-Typ, wie 2-Hydroxybenzophenon, 2-Hydroxy-4-alkoxybenzophenon, worin die Alkoxygruppe 1 bis 12 C-Atome enthält, 2,4-Dihydroxybenzophenon oder 2,2′-Dihydroxy-4,4′-dimethoxybenzophenon geeignet.

Geeignete sublimierbare Farbstoffe, die in den Farbbändern vom Sublimationstyp enthalten sein können, sind beispielsweise Cibacet Gelb 2GC (Ciba-Geigy AG), Dimethyl Gelb (Fluka) und Terasil Gelb (Ciba-Geigy AG).

Als im Bereich von 350 bis 450 nm lichtempfindliche positiv arbeitende Photopolymere, mit denen die Metallplatte beschichtet ist, können beispielsweise Gemische aus o-Chinondiaziden und Novolaken (vgl. J. Kosar, "Light Sensitive Systems", John Wiley & Sons, New York, 1965) oder Gemische, enthaltend Verbindungen mit einer säurespaltbaren Acetalbindung, photochemisch aktivierbare Säurespender und wässrig-alkalisch lösliche Bindemittel verwendet werden. Solche positiv arbeitende Zusammensetzungen werden beispielsweise in der DE-AS 2,718,254, in der US-PS 3,779,778 oder in der EP-Anmeldung 0 202 196 beschrieben.

Für die Metallplatten verwendet man als Trägermaterial vorzugsweise mechanisch oder elektrochemisch aufgerautes, gegebenenfalls anodisiertes Aluminium, das eventuell noch chemisch vorbehandelt sein kann, zum Beispiel mit Silikaten oder Phosphaten. Ferner eignen sich als Trägermaterial Zink oder Mehrmetallplatten mit Cu/Cr oder Messing/Cr als oberste Schicht.

Auf die mit dem Photopolymer beschichtete Metallplatte wird anschliessend auf den Photopolymerfilm noch eine Deckschicht aus einem filmbildenden, in der alkalischen Entwicklerlösung löslichen Polymer, das im Bereich von 350 bis 450 nm lichtdurchlässig ist,
aufgetragen. Als solche Polymere eignen sich beispielsweise Polyvinylalkohole, Alkylhydroxyalkylcellulose, Polyacrylsäure, Derivate der Polyacrylsäure, Polyacrylamide, Polyvinylpyrrolidone, Polyvinylmethyläther, Copolymere aus Maleinsäureanhydrid und Vinyl- oder Acrylverbindungen und Phenolharze, die durch Kondensation von Phenolen mit Aldehyden erhalten werden. Geeignete Phenole sind beispielsweise Phenol, Kresol, Aethylphenol, Butylphenol oder Bisphenol A, und geeignete Aldehyde sind beispielsweise Formaldehyd, Acetaldehyd, Acrolein, Crotonaldehyd oder Furfurol. Vorzugsweise verwendet man als Deckschicht einen Polyvinylalkohol oder ein Phenolharz.

Zur Herstellung der Photomaske auf der PS-Platte können die üblichen, im Handel erhältlichen Thermotransferdrucker verwendet werden.

Die photochemische Veränderung erfolgt nach der bekannten Methode der Photozersetzung durch Bestrahlung mit Licht, das reich an kurzwelliger Strahlung ist. Als Lichtquellen sind z.B. Quecksilbermitteldruck-, -hochdruck- und -niederdruckstrahler, sowie superaktinische Leuchtstoffröhren geeignet, deren Emissionsmaxima im Bereich zwischen 350 und 450 nm liegen. Die Belichtungsdauer richtet sich nach der Lichtintensität und der Lichtempfindlichkeit des verwendeten Photopolymers und beträgt im allgemeinen zwischen 20 und etwa 60 Sekunden. Nach dem Entwickeln der belichteten PS-Platte in einer alkalischen Entwicklerlösung, wobei die Deckschicht und die lichtzersetzten Anteile des Photopolymers herausgelöst werden, erhält man nach anschliessender Trocknung eine fertige Druckplatte, die beispielsweise für den Offsetdruck geeignet ist.

In den folgenden Beispielen werden folgende Materialien und Geräte eingesetzt:

PS-Platte (presensitized plate):

Diese wird hergestellt, indem man eine elektrochemisch oder mechanisch aufgerauhte, gegebenenfalls anodisierte Aluminiumplatte mit einer Photopolymerlösung, bestehend aus einer Mischung von 1 Gew.-Teil eines Naphthochinon-1,2-diazido-5-sulfonsäureesters des Polyhydroxyphenyls, hergestellt durch Polykondensation von Aceton und Pyrogallol gemäss Beispiel 1 des US-Patentes 3,635,709, und 2 Gew.-teilen eines Phenolnovolaks, gelöst in einem Lösungsmittelgemisch bestehend aus 20 Gew.-teilen 2-Methoxyäthylacetat und 20 Gew.-teilen Methyläthylketon, beschichtet und anschliessend trocknet. Schichtdicke:1-3 um, Trocknungsbedingung: 5 Minuten/60°C.

Entwicklerlösung:

Alkalische Lösung bestehend aus 75 g Natriummetasilika-pentahydrat (Fluka) und 0,4 g eines nichtionischen Netzmittels (Supronic B50 von ABM Chemicals Ltd.) in 1000 g Wasser.

Thermotransferdrucker:

Thermo-Transfer-Drucker HR-5 der Firma Brother Corp. Dieser Drucker ist mit einem Thermokopf ausgerüstet, der es ermöglicht, dass sowohl Farbbänder vom Schmelztyp als auch vom Sublimationstyp verwendet werden können.

Belichtungsgerät:

Quecksilberlampe M0 25, 2kW, der Firma Silvania.

Beispiel 1:

Unter Verwendung eines schwarzen, im Handel unter der Bezeichnung "Cassette Ribbon 6040" erhältlichen Farbbandes der Firma Brother Corp. wird eine Information ab Computer mittels des Thermotransferdruckers direkt auf die mit einem Polyvinylalkohol (Moviol 4-88 der Firma Hoechst AG) 2-3 μm dünn beschichtete PS-Platte geschrieben. Danach wird diese mit der Quecksilberlampe 30 Sekunden lang belichtet, wobei die Lichtintensität an der PS-Plattenoberfläche etwa 1 $mW/cm^2$ beträgt. Anschliessend wird die belichtete PS-Platte mit der Entwicklerlösung entwickelt, wobei die dünne Polyvinylalkohol-Schicht entfernt wird und die belichteten, zersetzten Stellen der PS-Platte herausgelöst werden. Nach dem Trocknen erhält man eine fertige Druckplatte für den Offsetdruck mit einer sehr guten Abriebfestigkeit (Auflagenhöhe >100'000) und guten Druckeigenschaften, insbesondere bezüglich Farbabnahme und Auflösungsvermögen.

Beispiel 2:

Beispiel 1 wird wiederholt, wobei anstelle des schwarzen nun ein gelbes Farbband, bestehend aus 20 Gew.-% Cromophthal Gelb 6G (Ciba-Geigy AG) und 80 Gew.-% Karnaubawachs verwendet wird. Nach Belichtung und Entwickeln wie in Beispiel 1 erhält man eine fertige Druckplatte.

Beispiel 3:

Beispiel 1 wird unter Verwendung eines Sublimationsfarbbandes, ein auf Kondensatorpapier aufgedampftes Band aus Cibacet 2GC (Ciba-Geigy AG), wiederholt. Nach Belichtung und Entwickeln wie in Beispiel 1 erhält man eine fertige Druckplatte.

Beispiel 4:

Beispiel 1 wird unter Verwendung eines Sublimationsfarbbandes, das durch Giessen einer Suspension aus Nitrocellulose und Terasil Gelb 2GW (Ciba-Geigy AG) auf Kondensatorpapier erhalten wird, wiederholt. Nach Belichtung und Entwickeln wie in Beispiel 1 erhält man eine fertige Druckplatte.

## Patentansprüche

1. Verfahren zur Herstellung einer Photomaske auf einer sich auf einer Metallplatte befindenden Schicht eines lichtempfindlichen, positiv arbeitenden Photopolymer, durch bildweises Aufzeichnen elektronisch kodierter Informationsquellen eines Thermotransferdruckers mittels eines Farbbands, dadurch gekennzeichnet, dass (a) das Photopolymer im Bereich von 350 bis 450 nm lichtempfindlich ist, (b) das Farbband ein Pigment oder einen Farbstoff enthält, welche im Bereich von 350 bis 450 nm Licht absorbieren, (c) auf der Photopolymerschicht eine Deckschicht aus einem in alkalischer Lösung löslichen und im Bereich von 350 bis 450 nm lichtdurchlässigen Polymer aufgebracht ist und die Photomaske direkt auf diese Deckschicht aufgezeichnet wird.

2. Verfahren gemäss Anspruch 1, dadurch gekennzeichnet, dass das Farbband ein gelbes, rotes, grünes oder schwarzes Pigment oder einen gelben, roten, grünen oder schwarzen Farbstoff enthält, welche im Bereich von 350 bis 450 nm Licht absorbieren.

3. Verfahren gemäss Anspruch 2, dadurch gekennzeichnet, dass das Farbband ein gelbes Pigment oder einen gelben Farbstoff enthält.

4. Verfahren gemäss Anspruch 1, dadurch gekennzeichnet, dass das Farbband ein blaues Pigment oder einen blauen Farbstoff und Aufheller oder UV-Absorber enthält.

5. Verfahren gemäss Anspruch 1, dadurch gekennzeichnet, dass das Farbband ein Schmelzfarbband ist.

6. Verfahren gemäss Anspruch 5, dadurch gekennzeichnet, dass das Farbband etwa 20 Gew.-% eines Pigmentes, etwa 60 bis 80 Gew.-% Wachs und 0 bis etwa 20 Gew.-% übliche Zusätze enthält.

7. Verfahren gemäss Anspruch 6, dadurch gekennzeichnet, dass das Farbband zusätzlich etwa 5 Gew.-% eines optischen Aufhellers oder eines UV-Absorbers enthält, welche im Spektralbereich, in dem das Photopolymer lichtempfindlich ist, Licht absorbieren.

8. Verwendung der gemäss Anspruch 1 erhältlichen Metallplatten zur Herstellung von Druckplatten.

## Claims

1. A process for the production of a photomask on a layer, on a metal plate, of a photosensitive positively working photopolymer, by imagewise recording of electronically coded sources of information of a thermal transfer printer by means of an ink ribbon, wherein (a) the photopolymer is sensitive to light in the range from 350 to 450 nm, (b) the ink ribbon contains a pigment or a dye, which absorbs light in the range from 350 to 450

nm, and (c) a covering layer consisting of a polymer which is soluble in alkaline solution and is permeable to light in the range from 350 to 450 nm is applied on the photopolymer layer, and the photomask is recorded directly on this covering layer.

2. A process according to claim 1, wherein the ink ribbon contains a yellow, red, green or black pigment or a yellow, red, green or black dye, which absorbs light in the range from 350 to 450 nm.

3. A process according to claim 2, wherein the ink ribbon contains a yellow pigment or a yellow dye.

4. A process according to claim 1, wherein the ink ribbon contains a blue pigment or a blue dye and a fluorescent whitening agent or UV-absorber.

5. A process according to claim 1, wherein the ink ribbon is a melt-type ink ribbon.

6. A process according to claim 5, wherein the ink ribbon contains about 20 % by weight of a pigment, about 60 to 80 % by weight of wax, and 0 to about 20 % by weight of conventional additives.

7. A process according to claim 6, wherein the ink ribbon additionally contains about 5 % by weight of a fluorescent whitening agent or of a UV-absorber, which absorbs light in the spectral region in which the photopolymer is photosensitive.

8. The use of the metal plates obtainable according to claim 1 for the production of printing plates.

## Revendications

1. Procédé pour créer un photomasque sur une couche, se trouvant sur une plaque métallique, d'un photopolymère photosensible fonctionnant en positif, par enregistrement, conformément à une image, de sources d'informations codées électroniquement d'une imprimante à transfert thermique, au moyen d'un ruban encreur, procédé caractérisé en ce que :

a) le photopolymère est sensible à la lumière dans l'intervalle de longueur d'onde allant de 350 à 450 nm,

b) le ruban encreur contient un pigment ou un colorant qui absorbe la lumière dans l'intervalle allant de 350 à 450 nm,

c) sur la couche de photopolymère est appliquée une couche de recouvrement en un polymère laissant passer la lumière dans l'intervalle de longueur d'onde allant de 350 à 450 nm et soluble dans une solution alcaline, et on enregistre le photomasque directement sur cette couche de recouvrement.

2. Procédé selon la revendication 1 caractérisé en ce que le ruban encreur contient un pigment jaune, rouge, vert ou noir ou un colorant jaune, rouge, vert ou noir qui absorbe la lumière dans la région allant de 350 à 450 nm.

3. Procédé selon la revendication 2 caractérisé en ce que le ruban encreur contient un pigment jaune ou un colorant jaune.

4. Procédé selon la revendication 1 caractérisé en ce que le ruban encreur contient un pigment bleu ou un colorant bleu et un azureur ou un absorbeur de rayons ultra-violets.

5. Procédé selon la revendication 1 caractérisé en ce que le ruban encreur est un ruban encreur du type à fusion.

6. Procédé selon la revendication 5 caractérisé en ce que le ruban encreur contient environ 20 % en poids d'un pigment, d'environ 60 à 80 % en poids d'une cire et de 0 à environ 20 % en poids d'additifs usuels.

7. Procédé selon la revendication 6 caractérisé en ce que le ruban encreur contient en outre environ 5 % en poids d'un azureur optique ou d'un absorbeur de rayons ultra-violets, qui absorbent la lumière dans la région spectrale dans laquelle le photopolymère est photosensible.

8. Application des plaques métalliques qui peuvent être obtenues selon la revendication 1 à la fabrication de clichés d'impression.